# EUROPEAN PATENT APPLICATION

(11) **EP 2 863 724 A2**
(43) Date of publication of application: **22.04.2015**
(21) Application number: 14188773.7
(22) Date of filing: 14.10.2014
(51) Int. Cl.: H05K 7/14

(54) **Method and system for detection of a circuit board to be installed in an apparatus and apparatus**

(30) Priority: 17.10.2013 FI 20136030
(71) Applicant: ABB Oy, 00380 Helsinki (FI)
(72) Inventor: Hellman, Jouko, 00380 Helsinki (FI); Niemi, Mika, 00380 Helsinki (FI)
(74) Representative: Seppo Laine Oy

(57) **Abstract**

The present invention concerns a method and system for detection of a circuit board to be installed in an apparatus such as an electric drive. At least one first element is fixedly arranged at at least one defined position on the surface of the circuit board and at least one second element is fixedly arranged at at least one defined position in a housing of the circuit board. The at least one first element interacts with the at least one second element during installation of the required circuit board. A matching signal or decoding signal is generated when the first element and the second element interact. The invention further concerns an apparatus such as an electric drive with at least one circuit board arranged in a housing.

## Description

### TECHNICAL FIELD OF THE INVENTION:

The present invention relates to a method and system for detection of a circuit board to be installed in an apparatus such as an electric drive. The invention further relates to an apparatus such as an electric drive with at least one circuit board installed in a housing.

### BACKGROUND OF THE INVENTION:

US 2006/0094295 A1 teaches that an apparatus of large scale such as a router, a communication control unit, or a plant control unit has a plurality of printed circuit boards. These printed circuit boards have inventory information including, for example, a manufacturing date, a manufacturing serial number, a drawing number, a version number, a name, a date of mounting, a final maintenance date or an actual mounting position showing the mounting position on the apparatus of the printed circuit board. Such inventory information is referred to and confirmed when managing the stock of printed circuit boards, mounting the printed circuit board on an apparatus, checking or replacing the printed circuit board or repairing the printed circuit board. According to the application a wireless ID tag including a contact interface, a non-contact interface and storing means for storing information is attached to the printed circuit board. When the printed circuit board is mounted on the apparatus, and both the printed circuit board and the apparatus operate normally, the actual mounting position of the printed circuit board is written into the storing means of the wireless ID tag when the printed circuit board is mounted on the apparatus. Therefore, the information about the actual mounting position of the printed circuit board can be easily readout from the storing means of the wireless ID tag, and checked whether or not to coincide with the predetermined mounting position.

US 2011/0276279 A1 teaches that an exemplary electric drive system has a plural number of electric drive subsystems. Each subsystem has a fault diagnostics arrangement, where the arrangement includes a control board for each subsystem. Event data of each subsystem is recorded on the respective control board, and one of the respective control boards of the electric drive system is a main control board of the electric drive system. Event data of a subsystem is transferred from the respective control board to the main control board through a data transfer medium.

According to ABB, ACS800, page 22, URL: http://www05.abb.com/global/scot/scot201.nsf/veritydisplay/ 771915535b9d25f3c12573f3004a77b2/$file/en_acs800_04_cabinet _inst_b_scrres_part%201.pdf, viewed on August 7, 2013 an ACS800-04 drive contains the following printed circuit boards as standard: main circuit board (AINT), motor control and I/O board (RMIO) with a fiber optic link to the AINT board, input bridge control board (AINP), input bridge protection board (AIBP) which includes snubbers for the thyristors and varistors, power supply board (APOW), gate driver control board (AGDR), diagnostics and panel interface board (ADPI) and brake chopper control board (ABRC).

US 6,246,334 B1 teaches that PCs and servers often contain one or more slots, which may be populated with circuit boards performing a variety of functions. Each board is typically identified by an identification (ID) number which is conveyed to the application software for use in running the application. In instances where there may be boards of different types, each board ID number is associated with a particular board type, and the application then knows each board ID number and its corresponding board type. To ascertain the board ID number, the operator has to open the computer case and to locate the switches or jumpers and to translate the switch arrangement into a recognizable board ID number. To overcome the problems of the invention a board ID number is assigned via the application software, and the identity of the board is displayed on an LED, LCD or other display which is viewable from the portion of the board which is visible outside of the computer case.

US 5,003,251 describes that a bar code is applied to a printed circuit board and uniquely identifies the board. When the circuitry on the board undergoes testing and evaluation, the results are stored in computer memory along with the identification number. Subsequent to the time of testing, if anyone is interested in reviewing the original test data, he need only scan the bar code which will indirectly address the test data. The bar code may be permanently programmed into an LCD which is mounted on the board, or may be permanently affixed to the board on a label.

US 2013/0126321 A1 discloses a microswitch for detecting a predetermined object to be detected. The microswitch includes a housing in which fixed side contact points, a movable side contact point and plate springs are incorporated, a plunger for transmitting power to the plate spring, and a lever member whose one end is supported by the housing. The lever member is a plate spring.

US 2010/0194451 A1 discloses a method for controlling an IGBT component and a gate driver. IBGTs are power semiconductor components which are used, for example, as switches in high power applications. An IGBT is a gate controlled component, which can be turned on and off from its gate. IBGTs can include a gate drive circuit unit which is able to quickly charge the internal capacitances of the component for turning on the component. Similarly, the drive circuit can remove the charge from the gate for cutting the current from the component. The gate drivers are connected to the gate and emitter terminals of the components, and a purpose of the driver is to control the potential of the gate with respect to the emitter.

### SUMMARY OF THE INVENTION:

An apparatus of large scale, for example an industrial electric drive, normally contains a plurality of circuit boards of different types, e.g. a main circuit board and a gate driver control board, which are interconnected using cables. In some drives more than one circuit board of one type may be installed. Some circuit boards of one type further differ for example only in the configuration of the jumpers, so that the boards have a similar or identical outer appearance. Circuit boards of different types can have similar or identical outer appearance as well. Therefore barcodes are usually attached to the circuit boards to identify the type of board or configuration of board by a barcode reader. Other identification systems, for example radio frequency identification (RFID), can also be used for the purpose of identifying and tracking tags attached to the circuit boards.

During production of an apparatus an electrician or any other person may interconnect two circuit boards which should not be interconnected. This may especially happen when one of the circuit boards installed in the apparatus is not of the type required or of the wrong configuration.

To avoid interconnection of two circuit boards, which should not be interconnected, therefore elaborate installation of the circuit boards is necessary. The interconnecting cables can be coloured or otherwise marked and may be of a predetermined length to facilitate precise interconnection of the circuit boards. Nevertheless false interconnection of circuit boards takes place during production of apparatuses. Fault detection and correction of defects increase production costs and may delay the product delivery to the customer.

The embodiments of the present invention are based on the object to ensure installation of a required circuit board in a corresponding housing in an apparatus. An unintentional installation of a circuit board in a housing, which is not required to be installed in the housing, should be avoided. The embodiments of the invention are particularly useful in production of apparatuses such as electric drive systems with a plurality of circuit boards. The circuit boards can be installed in the corresponding housings without unintentionally interconnecting circuit boards which should not be interconnected. Another object of the embodiments of the present invention is to provide a method and a system for detection of a circuit board to be installed in an apparatus such as an electric drive, wherein installation of the required circuit board is ensured.

These and other objects are achieved by the embodiments of the present invention, as hereinafter described and claimed. According to an aspect of the invention, there is provided a method for detection of a circuit board to be installed in an apparatus such as an electric drive, wherein
- at least one first element is fixedly arranged at at least one defined position on the surface of the circuit board, the at least one defined position on the circuit board depending on the type of the circuit board and/or the configuration of the circuit board,
- at least one second element is fixedly arranged at at least one defined position in a housing of the circuit board or on the surface of a second circuit board, the at least one defined position in the housing or on the second circuit board depending on the required type of the circuit board and/or the required configuration of the circuit board to be installed in the apparatus,
- the at least one first element arranged on the surface of the circuit board is adapted to interact with the at least one second element arranged in the housing of the circuit board or on the second circuit board during installation of the required circuit board in the housing of the circuit board or to the second circuit board, whereat the interaction between the at least one first element and the at least one second element is of mechanical, electrical, electronic, magnetic, thermal and/or optical kind, and
- a matching signal or decoding signal is generated when the first element and the second element interact.

In an embodiment, the matching signal or decoding signal is an acoustic signal, a visual signal, an electric signal or an electronic signal.

In another embodiment, information such as a manufacturing date, a manufacturing serial number, a drawing number, a version number, a name, a date of mounting, a final maintenance date or an actual mounting position showing the mounting position on the apparatus of the circuit board is transmitted to a database, a diagnostics arrangement or a software after a matching signal or decoding signal is generated.

According to another aspect of the invention, the object of the embodiments can be also achieved by a system for detection of a circuit board to be installed in an apparatus such as an electric drive with at least one circuit board installed in a housing or connected to a second circuit board, the system comprising:
- at least one first element is fixedly arranged at at least one defined position on the surface of the circuit board, the at least one defined position on the circuit board depending on the type of circuit board and/or the configuration of the circuit board, and
- at least one second element is fixedly arranged at at least one defined position in the housing of the corresponding circuit board or on the surface of the second circuit board, the at least one defined position in the housing or on the second circuit board depending on the required type of the circuit board and/or the required configuration of the circuit board to be installed in the apparatus.

According to an embodiment, the at least one first element may be a microswitch element, a jump wire element, a detecting contact element, a screw pillar, a thermistor element, a LED element and a phototransistor element and/or a bump element. The at least one second element further preferably comprises a pen-like element or protrusion, a jump wire element, a conducting element, a screw, a heat conductor element, a measurement spot, a wall-like element and/or an optical fork sensor element.

According to a further aspect of the invention, the object of the embodiments of the invention can be also achieved by an apparatus such as an electric drive with at least one circuit board installed in a housing or connected to a second circuit board, wherein
- at least one first element is fixedly arranged at at least one defined position on the surface of the circuit board, the at least one defined position on the circuit board depending on the type of circuit board and/or the configuration of the circuit board, and
- at least one second element is fixedly arranged at at least one defined position in the housing of the corresponding circuit board or on the surface of the second circuit board, the at least one defined position in the housing or on the second circuit board depending on the required type of the circuit board and/or the required configuration of the circuit board to be installed in the apparatus.

In an embodiment, the at least one circuit board to be installed in a housing of the apparatus or to a second circuit board comprises a main circuit board, a motor control and I/O board, an input bridge control board, an input bridge protection board, a power supply board, a gate driver control board and/or a brake chopper control board.

In another embodiment, at least two circuit boards are included in the apparatus which are interconnected using cables. According to an embodiment, at least one signal processing unit is preferably included in the apparatus. According to another embodiment, a required circuit board to be installed is connected to a second circuit board instead of the housing.

Depending on the type or configuration of the required circuit board to be installed in the corresponding housing the at least one second element is fixedly arranged at a defined position in the housing. The defined arrangement position of the at least one second element in the housing may differ for every circuit board of different type or configuration to be installed. Also the defined arrangement position of the at least one first element on the surface of the circuit board may differ for every circuit board of different type or configuration. Therefore only the at least one first element of the required circuit board to be installed in the corresponding housing can interact with the at least one second element.

Considerable advantages are obtained by means of the embodiments of the invention. Fault detection and correction of defects leading to an increase of production costs and a delay of product delivery to the customer because of installation of an unrequired circuit board can be avoided. Damage of circuit boards resulting from unintentional installation of unrequired circuit boards in housings and false interconnection of the circuit boards can be also avoided.

Installation positions of the required circuit boards always coincide with their predetermined mounting positions. Automatic configuration of the apparatus and/or circuit board may take place immediately after generation of a matching signal or decoding signal. It is not necessary to open the housing and to locate the switches or jumpers and to translate the switch arrangement into a recognizable board ID number to identify a circuit board.

Using a plurality of first and/or second elements, circuit boards of a type or configuration which may be installed in different apparatuses can further identify the apparatus, for example a 500 [V] or 690 [V] electric drive, and configure automatically.

False interconnection of circuit boards which may lead to false control signals, for example to an IGBT component, can be avoided as well. Furthermore false cross-interconnection of circuit boards to a main control board or any other board can be detected and correction of the defect can take place automatically without replacing the crossing circuit boards in corresponding housings by changing control signals. Damage of other devices, for example a motor or a fire system, leading to dangerous situations during operation of an apparatus can be therefore avoided. Thus, the invention may also increase the safety of other products, for example railways or ships.

The at least one first element and the at least one second element according to the present invention are furthermore not cost intensive and easy to mount.

### BRIEF DESCRIPTION OF THE DRAWINGS:

For a more complete understanding of particular embodiments of the present invention and their advantages, reference is now made to the following descriptions, taken in conjunction with the accompanying drawings. In the drawings:
**Fig. 1** illustrates a schematic view of a cabinet line-up example of an ABB ACS880 drive,
**Fig. 2** illustrates a schematic view of a first embodiment of the invention,
**Fig. 3** illustrates a schematic view of an installation of an unrequired circuit board in a housing,
**Fig. 4** illustrates a schematic view of a second embodiment of the invention,
**Fig. 5** illustrates a schematic view of an installation of an unrequired circuit board in a housing,
**Fig. 6** illustrates a schematic view of a third embodiment of the invention,
**Fig. 7** illustrates a schematic view of an installation of an unrequired circuit board in a housing,
**Fig. 8** illustrates a schematic view of a fourth embodiment of the invention,
**Fig. 9** illustrates a schematic view of a fifth embodiment of the invention,
**Fig. 10** illustrates a schematic view of a sixth embodiment of the invention,
**Fig. 11** illustrates a schematic view of a seventh embodiment of the invention,
**Fig. 12** illustrates a schematic view of an eighth embodiment of the invention, and
**Fig. 13** illustrates a schematic view of a ninth embodiment of the invention.

### DETAILED DESCRIPTION OF THE INVENTION:

The present invention may be used in any apparatus 1 wherein precise installation of circuit boards 2 is required. The present invention may be in particular used in production of industrial electric drive systems.

Industrial electric drives are designed for various industrial applications, especially for applications in process and manufacturing industries such as pulp & paper, metals, mining, cement, power, chemical, and oil & gas industries. In energy industry, electric drives can be for example used in turbines of wind power systems or in solar power systems. In transport devices, electric drives can be also used for example in railways or ships.

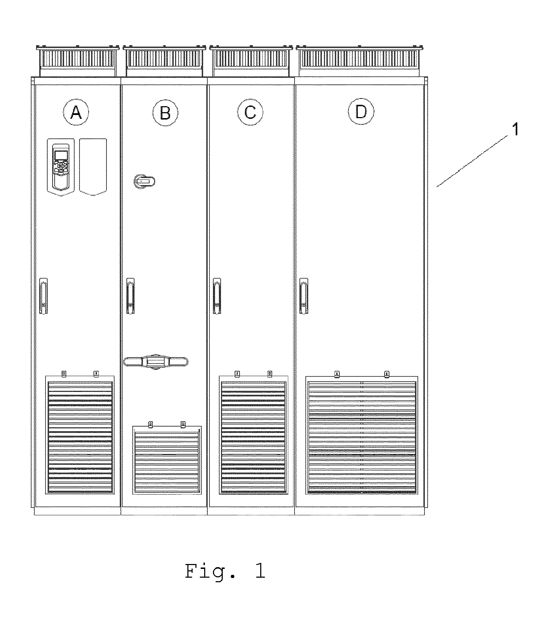

In **Fig. 1** a cabinet line-up example of an ABB ACS880 drive with one D8T supply module and two R8i inverter modules is shown. The apparatus 1 consists of an auxiliary control cubicle A, which contains control electronics and customer I/O connections, an incoming cubicle B, which contains the power input cable terminals and switchgear, a supply module cubicle C, which contains the D8T supply module, and an inverter module cubicle D, which contains two R8i inverter modules. Circuit boards 2 may be for example installed in the auxiliary control cubicle A, the incoming cubicle B, the supply module cubicle C and/or the inverter module cubicle D.

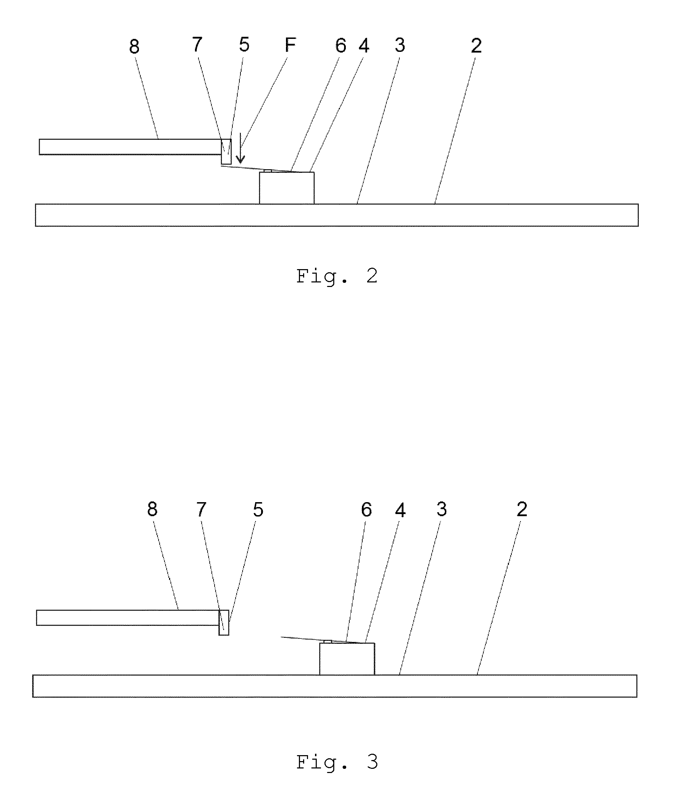

In **Fig. 2** a schematic view of a first embodiment of the invention is shown. At least one microswitch element 6, i.e. a first element 4, is fixedly arranged at a defined position on the surface 3 of a circuit board 2. In a corresponding housing 8 of the circuit board 2 at least one pen-like element or protrusion 7, i.e. a second element 5, is fixedly arranged at a defined position. During installation of a required circuit board 2 in the housing 8 of the circuit board 2 the microswitch element 6 arranged on the circuit board 2 is brought into contact with the pen-like element or protrusion 7 arranged in the housing 8 of the circuit board 2. The pen-like element or protrusion 7 exerts a mechanical force and closes the at least one microswitch element 6. When the microswitch element 6 is closed a signal is generated that the required circuit board 2 has been detected. The installation position of the required circuit board 2 then coincides with the predetermined mounting position.

Information including, for example, a manufacturing date, a manufacturing serial number, a drawing number, a version number, a name, a date of mounting, a final maintenance date or an actual mounting position showing the mounting position on the apparatus of the printed circuit board may then be transmitted to a database, a diagnostics arrangement or a software.

The at least one pen-like element or protrusion 7 fixedly arranged at a defined position in the housing 8 may be made of the housing material or any other material, e.g. a metal. The pen-like element or protrusion 7 may be of a non-conductive or conductive material. In particular the pen-like element or protrusion 7 may be a part of the housing 8 made of the housing material. Thus no other part has to be mounted in the housing 8 during production of the housing 8. Leaving mounting of the pen-like element or protrusion 7 undone can be this way excluded during production of the housing 8.

Depending on the type or configuration of the required circuit board 2 to be installed in the corresponding housing 8 each pen-like element or protrusion 7 is fixedly arranged at a defined position in the housing 8. The defined arrangement position of the pen-like element 7 in the housing 8 may differ for every circuit board of different type or configuration. Also the defined arrangement position of the microswitch element 6 on the circuit board 2 may differ for every circuit board 2 of different type or configuration. Therefore only the microswitch element 6 of the required circuit board 2 to be installed in the corresponding housing 8 can be brought into contact with the pen-like element or protrusion 7.

**Fig. 3** shows a schematic view of an unintentional installation of an unrequired circuit board 2 in a housing 8. The pen-like element or protrusion 7 and the microswitch element 6 cannot be brought into contact in the housing 8 of the circuit board 2 during installation of the circuit board 2 in the housing 8 of the circuit board 2. As no matching signal can be generated, the circuit board 2 installed in the housing 8 is not of the type required or of the wrong configuration.

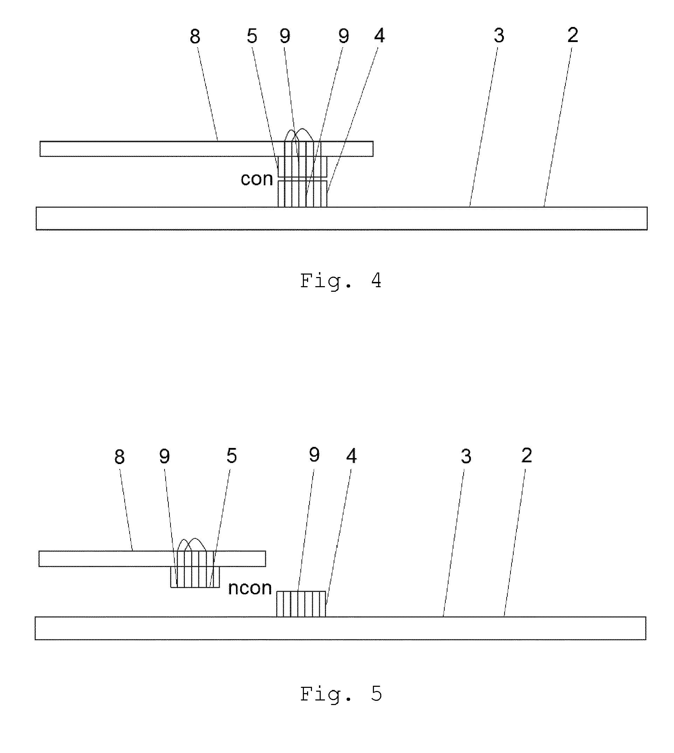

**Fig. 4** shows a schematic view of a second embodiment of the invention. A jump wire element 9, i.e. a first element 4, is fixedly arranged at a defined position on the surface 3 of a circuit board 2. In a corresponding housing 8 of the circuit board 2 a jump wire element 7, i.e. a second element 5, is fixedly arranged at a defined position. During installation of the required circuit board 2 in the housing 8 of the circuit board 2 the jump wire element 9 arranged on the circuit board 2 is brought into contact with the jump wire element 9 arranged in the housing 8 of the circuit board 2. The jump wire element 9 arranged in the housing 8 can close an electric circuit and then the circuit board 2 can detect if there is an interconnection between the jump wire element 9 arranged on the surface 3 of the circuit board 2 and the jump wire element 9 arranged in the housing 8 or not. When the electric circuit is closed an expected signal is generated that the required circuit board 2 has been detected. The installation position of the required circuit board 2 then coincides with the predetermined mounting position. During installation of an unrequired circuit board 2 jump wire elements 9 fixedly arranged in the housing 8 and on the surface 3 of the circuit board 2 may further be brought into contact. Interconnection may then lead to generation of an unexpected signal. In this case the circuit board 2 installed in the housing 8 is not of the type required or of the wrong configuration. Required and unrequired circuit boards 2 or circuit boards 2 of different configuration may have different arrangements of jump wire elements 9. Different arrangements of jump wire elements 9 may be detected by the circuit board 2 to be installed.

**Fig. 5** shows a schematic view of an unintentional installation of an unrequired circuit board 2 in a housing 8. The jump wire element 9 fixedly arranged on the surface 3 of the circuit board 2 and the jump wire element 9 fixedly arranged in the housing 8 cannot be brought into contact in the housing 8 of the circuit board 2 to close the electric circuit during installation of the circuit board 2 in the housing 8 of the circuit board 2. As no matching signal can be generated, the circuit board 2 installed in the housing 8 is not of the type required or of the wrong configuration. The jump wire elements 9 fixedly arranged in the housing 8 and on the surface 3 of the circuit board 2 may further partially overlap which is not shown in Fig. 5. Partial overlapping of jump wire elements 9 may lead to generation of an unexpected signal. In this case the circuit board 2 installed in the housing 8 is also not of the type required or of the wrong configuration.

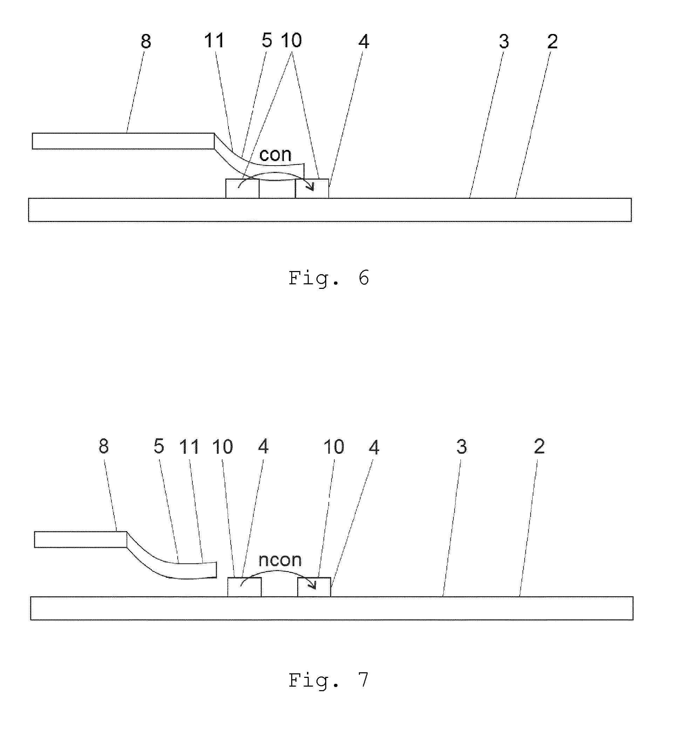

In **Fig. 6** a schematic view of a third embodiment of the invention is illustrated. Two detecting contact elements 10 are fixedly arranged at a defined position on the surface 3 of a circuit board 2. The two detecting contact elements 10 may be for example made of copper. In a corresponding housing 8 of the circuit board 2 a conducting element 11 is fixedly arranged at a defined position. The conducting element 11 is made of conductive material and may be preferably formed bow-like. During installation of the required circuit board 2 in the housing 8 of the circuit board 2 the two detecting contact elements 10 arranged on the circuit board 2 are brought into contact with the conducting element 11 arranged in the housing 2 of the circuit board 2. The conducting element 11 interconnects the detecting contact elements 10. When detecting contact elements 10 are interconnected, a signal is generated that the required circuit board 2 has been detected. The installation position of the required circuit board 2 then coincides with the predetermined mounting position.

**Fig. 7** shows a schematic view of an unintentional installation of an unrequired circuit board 2 in a housing 8. The two detecting contact elements 10 fixedly arranged on the surface 3 of the circuit board 2 and the conducting element 11 fixedly arranged in the housing 8 cannot be brought into contact in the housing 8 of the circuit board 2 to close the electric circuit during installation of the circuit board 2 in the housing 8 of the circuit board 2. As no matching signal can be generated, the circuit board 2 installed in the housing 8 is not of the type required or of the wrong configuration.

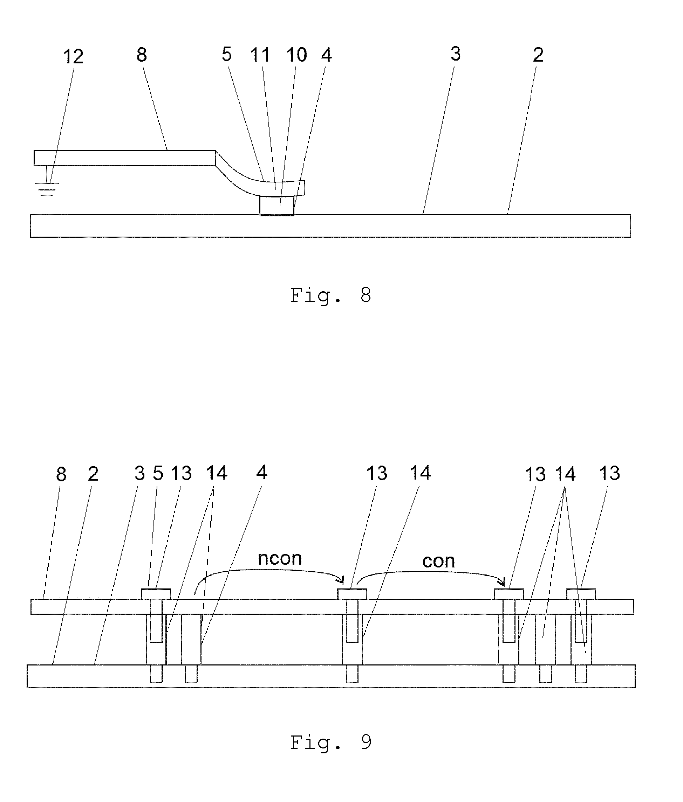

**Fig. 8** shows a schematic view of a fourth embodiment of the invention. A detecting contact element 10 is fixedly arranged at a defined position on the surface 3 of a circuit board 2. The detecting contact element 10 may be for example of copper. In a corresponding housing 8 of the circuit board 2 a conducting element 11 is fixedly arranged at a defined position. The conducting element 11 is made of conductive material and may be preferably formed bow-like. The housing 8 may be protective ground 12. During installation of the required circuit board 2 in the housing 8 of the circuit board 2 the detecting contact element 10 arranged on the circuit board 2 is brought into contact with the conducting element 11 arranged in the housing 8 of the circuit board 2. The circuit board 2 can detect if there is an interconnection between the detecting contact element 10 and the protective grounding 12 or not. When the detecting contact element 10 is interconnected a signal is generated that the required circuit board 2 has been detected. The installation position of the required circuit board 2 then coincides with the predetermined mounting position.

In **Fig. 9** a schematic view of a fifth embodiment of the invention is illustrated. Circuit boards 2 are often mounted in their corresponding housings 8 using screws 13. The screws 13 may be of conductive or non-conductive material. The circuit boards 2 may comprise several female screw threads or screw pillars 14. The housings 8 may have several borings for screws 13 which can correspond with some of the female screw threads or screw pillars 14. The circuit board 2 may for example include six screw threads or screw pillars 14. The housing 8 may for example include four borings which correspond with the first, third, fourth and sixth screw thread or screw pillar 14. For the second and fifth screw thread or screw pillar 14 there may be no corresponding opening in the housing 8 available. The housing 8 may be conductive and screws 13 arranged at the first, third, fourth and sixth screw thread or screw pillar 14 may conduct current to the circuit board 2. At the second and fifth screw thread or screw pillar 14 current cannot be conducted to the circuit board 2. The circuit board 2 can identify which screw threads or screw pillars 14 are used. The circuit board 2 can detect the mounting position depending on the conductivity or non-conductivity. When the expected screw threads or screw pillars 14 are interconnected with the housing, a signal is generated that the required circuit board 2 has been detected. The installation position of the required circuit board 2 then coincides with the predetermined mounting position. On the other side, interconnection of the first, second, third and fourth screw thread or screw pillar 14 with the housing 8 may be for example unexpected. Then the circuit board 2 installed in the housing 8 is not of the type required or of the wrong configuration. The number of borings in the housing, the number of screw threads or screw pillars 14, the number of screws, the position of borings, and/or the position of screw threads or screw pillars 14 may further vary for each circuit board 2 to be installed

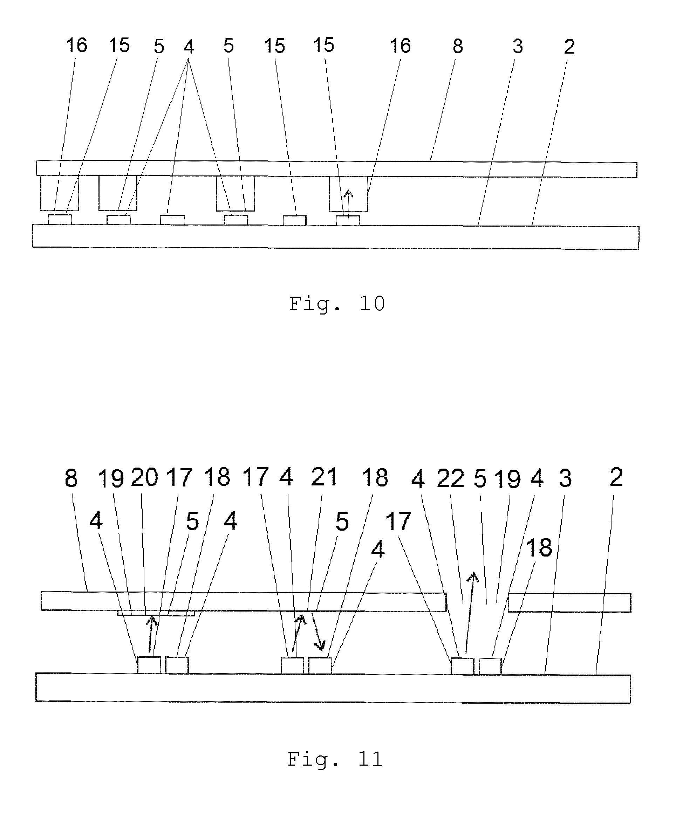

**Fig. 10** shows a schematic view of a sixth embodiment of the invention. On the surface 3 of the circuit board 2 at least one NTC or PTC thermistor element 15 may be arranged at a defined position whose resistance varies significantly with temperature. In a corresponding housing 8 of the circuit board 2 further at least one heat conductor element 16 is fixedly arranged at a defined position. The temperature of the at least one thermistor element 15 may be increased electrically. Depending on the type or configuration of the required circuit board 2 to be installed in the corresponding housing 8, the at least one heat conductor element 16 may be arranged in such a way in the housing 8 that during installation of the required circuit board 2 in the housing 8 of the circuit board 2 the temperature of the at least one thermistor element 15 may be decreased leading to a resistance variation of the at least one thermistor element 15. If the resistance of the at least one thermistor element 15 varies, a signal is generated that the required circuit board 2 has been detected. The installation position of the required circuit board 2 coincides with the predetermined mounting position. If the resistance of the at least one thermistor element 15 does not vary, an unrequired circuit board 2 of the wrong type or configuration has been installed.

In **Fig. 11** a schematic view of a seventh embodiment of the invention is shown. On the surface 3 of the circuit board 2 at least one light emitting diode (LED) 17 and at least one phototransistor 18 may be arranged at defined positions. On the surface of the housing 8 at least one measurement spot 19 may be further arranged at a defined position which may have a black surface 20, a white surface 21 or a polished metal surface 21 and faces the circuit board 2. A measurement spot 19 may also be an opening 22 in the wall of the housing 8. Depending on the type or configuration of the required circuit board 2 to be installed in the corresponding housing 8 the at least one measurement spot 19 is arranged in such a way on the surface of the housing 8 that during installation of the required circuit board 2 in the housing 8 of the circuit board 2 light emitted from the at least one LED 17 to the at least one measurement spot 19 may be for example reflected to the at least one phototransistor 18. Openings 22 in the wall of the housing 8 do not reflect any light emitted from a LED 17. Using a plurality of measurement spots 19 phototransistors 18 may achieve a predetermined light emission code - analogue to a barcode - and a signal may be generated that the required circuit board 2 has been detected. The installation position of the required circuit board 2 then coincides with the predetermined mounting position. If the phototransistors 18 do not achieve the predetermined light emission code, an unrequired circuit board 2 of the wrong type or configuration has been installed. Using a plurality of first elements 4, circuit boards 2 of a type or configuration which may be installed in different apparatuses 1 may identify the apparatus 1, for example a 500 [V] or 690 [V] electric drive, and configure automatically. Furthermore false cross-interconnection of at least two circuit boards 2 to a main control board or any other board can be detected and correction of the defect can take place automatically without replacing the crossing circuit boards 2 in corresponding housings 8 by changing control signals.

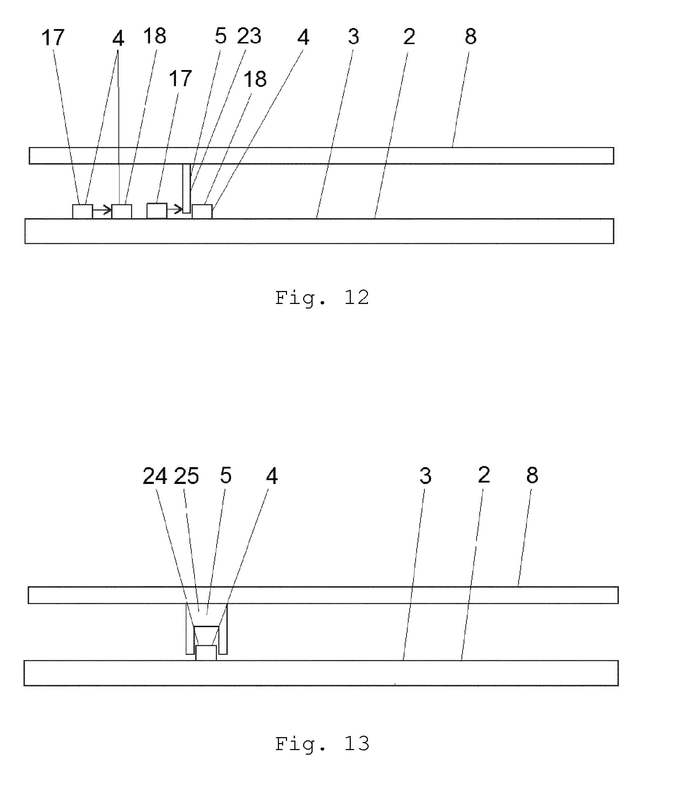

**Fig. 12** illustrates a schematic view of an eighth embodiment of the invention. On the surface 3 of the circuit board 2 at least one LED element 17 and at least one phototransistor element 18 may be arranged at defined positions. In a corresponding housing 8 of the circuit board 2 at least one wall-like element 23 is fixedly arranged at a defined position. Depending on the type or configuration of the required circuit board 2 to be installed in the corresponding housing 8, the at least one wall-like element 23 may be arranged in such a way in the housing 8 that during installation of the required circuit board 2 in the housing 8 of the circuit board 2 light emitted from the at least one LED element 17 may be blocked and thus the at least one phototransistor element 18 is not able to detect light. If light detection is interrupted, a signal is generated that the required circuit board 2 has been detected. The installation position of the required circuit board 2 then coincides with the predetermined mounting position. If light detection may not be interrupted, an unrequired circuit board 2 of the wrong type or configuration has been installed. Instead of at least one LED element 17 and at least one phototransistor element 18 at least one optical fork sensor element 25 may be horizontally arranged on the surface of the circuit board 2. The wall-like element 23 may interrupt the light beam of the optical fork sensor element 25. If light detection is interrupted, a signal is generated that the required circuit board 2 has been detected. The installation position of the required circuit board 2 then coincides with the predetermined mounting position.

In **Fig. 13** a schematic view of a ninth embodiment of the invention is shown. At least one bump element 24, i.e. a first element 4, is fixedly arranged at a defined position on the surface 3 of a circuit board 2. In a corresponding housing 8 of the circuit board 2 at least one optical fork sensor element 25, i.e. a second element 5, is vertically arranged at a defined position. During installation of a required circuit board 2 in the housing 8 of the circuit board 2 the light beam of the optical fork element 25 fixedly arranged in the housing 8 is interrupted and the bump element 24 is detected. When the bump element 24 is detected, a signal is generated that the required circuit board 2 has been detected. The installation position of the required circuit board 2 then coincides with the predetermined mounting position. There may be a plurality of bump elements 24 fixedly arranged at a defined position on the surface 3 of a circuit board 2 and/or optical fork elements 25 arranged in the housing 8. The bump element 24 may be further arranged in the housing 8 and the optical fork element 25 may be arranged on the surface of the circuit board 2.

Although the present invention has been described in detail for the purpose of illustration, various changes and modifications can be made within the scope of the claims. In addition, it is to be understood that the present disclosure contemplates that, to the extent possible, one or more features of any embodiment may be combined with one or more features of any other embodiment.

The at least one first element may be in particular arranged in the housing and the at least one second element may be arranged on the surface of the circuit board, respectively.

The present invention is further in particular not limited to circuit boards installed in electric drives. The invention may be used in any other system, apparatus or device wherein precise installation and/or interconnection of circuit boards is required.

The present invention can further also provide detection of the mounting position i = 1, 2, 3, ..., n, if there is more than one mounting position. The invention may for example provide detection of the mounting position in an apparatus with i = 10 mounting positions for circuit boards. After installation of a circuit board, e.g. in mounting position i = 7, a signal is generated that the required circuit board has been detected. Further, a mounting position signal is generated.

### List of reference numbers:

- 1: apparatus
- 2: circuit board
- 3: surface of the circuit board
- 4: first element
- 5: second element
- 6: microswitch element
- 7: pen-like element or protrusion
- 8: housing or metal enclosure
- 9: connector element
- 10: detecting contact element
- 11: conducting element
- 12: protective grounding
- 13: screw
- 14: screw pillar
- 15: NTC or PTC thermistor element
- 16: heat conductor element
- 17: LED element
- 18: phototransistor element
- 19: measurement spot
- 20: black surface
- 21: polished metal or white surface
- 22: opening
- 23: wall-like element
- 24: bump element
- 25: optical fork sensor element
- A: auxiliary control cubicle
- B: incoming cubicle
- C: supply module cubicle
- D: inverter module cubicle
- F: force
- con: conducting
- ncon: non-conducting

## Claims

1. Method for detection of a circuit board (2) to be installed in an apparatus (1) such as an electric drive, wherein
- at least one first element (4) is fixedly arranged at at least one defined position on the surface (3) of the circuit board (2), the at least one defined position on the circuit board (2) depending on the type of the circuit board (2) and/or the configuration of the circuit board (2),
- at least one second element (5) is fixedly arranged at at least one defined position in a housing (8) of the circuit board (2) or on the surface of a second circuit board, the at least one defined position in the housing (8) on the second circuit board (2) depending on the required type of the circuit board (2) and/or the required configuration of the circuit board (2) to be installed in the apparatus (1),
- the at least one first element (4) arranged on the surface of the circuit board (2) is adapted to interact with the at least one second element (5) arranged in the housing (8) of the circuit board (2) or on the surface of the second circuit board during installation of the required circuit board (2) in the housing (8) of the circuit board (2) or to the second circuit board, whereat the interaction between the at least one first element (4) and the at least one second element (5) is of mechanical, electrical, electronic, magnetic, thermal and/or optical kind, and
- a matching signal or decoding signal is generated when the first element (4) and the second element (5) interact.

2. The method according to claim 1, wherein the matching signal or decoding signal is an acoustic signal, a visual signal, an electric signal or an electronic signal.

3. The method according to claim 1 or 2, wherein information such as a manufacturing date, a manufacturing serial number, a drawing number, a version number, a name, a date of mounting, a final maintenance date or an actual mounting position showing the mounting position on the apparatus (1) of the circuit board (2) is transmitted to a database, a diagnostics arrangement or a software after a matching signal or decoding signal is generated.

4. A system for detection of a circuit board (2) to be installed in an apparatus (1) such as an electric drive with at least one circuit board (2) arranged in a housing (8) or connected to a second circuit board, the system comprising:
- at least one first element (4) is fixedly arranged at at least one defined position on the surface (3) of the circuit board (2), the at least one defined position on the circuit board (2) depending on the type of circuit board (2) and/or the configuration of the circuit board (2), and
- at least one second element (5) is fixedly arranged at at least one defined position in the housing (8) of the corresponding circuit board (2) or on the surface of the second circuit board, the at least one defined position in the housing (8) or on the second circuit board depending on the required type of the circuit board (2) and/or the required configuration of the circuit board (2) to be installed in the apparatus (1).

5. The system according to claim 4, wherein the at least one first element comprises a microswitch element (6), a jump wire element (9), a detecting contact element (10), a screw pillar (14), a thermistor element (15), a LED element (17) and a phototransistor element (18) and/or a bump element (24).

6. The system according to claim 4 or 5, wherein the at least one second element comprises a pen-like element or protrusion (7), a jump wire element (9), a conducting element (11), a screw (13), a heat conductor element (16), a measurement spot (19), a wall-like element (23) and/or an optical fork sensor element (25).

7. The system according to any of the claims 4 to 6, wherein the at least one circuit board (2) comprises a main circuit board, a motor control and I/O board, an input bridge control board, an input bridge protection board, a power supply board, a gate driver control board and/or a brake chopper control board.

8. An apparatus (1) such as an electric drive with at least one circuit board (2) installed in a housing (8) or connected to a second circuit board, wherein
- at least one first element (4) is fixedly arranged at at least one defined position on the surface (3) of the circuit board (2), the at least one defined position on the circuit board (2) depending on the type of circuit board (2) and/or the configuration of the circuit board (2), and
- at least one second element (5) is fixedly arranged at at least one defined position in the housing (8) of the corresponding circuit board (2) or on the surface of the second circuit board, the at least one defined position in the housing (8) or on the second circuit board depending on the required type of the circuit board (2) and/or the required configuration of the circuit board (2) to be installed in the apparatus (1).

9. The apparatus (1) according to claim 8, wherein the at least one first element comprises a microswitch element (6), a jump wire element (9), a detecting contact element (10), a screw pillar (14), a thermistor element (15), a LED element (17) and a phototransistor element (18) and/or a bump element (24).

10. The apparatus (1) according to claim 8 or 9, wherein the at least one second element comprises a pen-like element or protrusion (7), a jump wire element (9), a conducting element (11), a screw (13), a heat conductor element (16), a measurement spot (19), a wall-like element (23) and/or an optical fork sensor element (25).

11. The apparatus (1) according to any of the claims 8 to 10, wherein the at least one circuit board (2) to be installed comprises a main circuit board, a motor control and I/O board, an input bridge control board, an input bridge protection board, a power supply board, a gate driver control board and/or a brake chopper control board.

12. The apparatus (1) according to any of the claims 8 to 11, the apparatus (1) including at least two circuit boards (2) which are interconnected using cables.

13. The apparatus (1) according to any of the claims 8 to 12, the apparatus (1) including at least one signal processing unit.

14. The apparatus (1) according to any of the claims 8 to 13, the apparatus (1) including the circuit board (2) which is connected to the second circuit board.
